# EUROPEAN PATENT APPLICATION

(11) **EP 1 189 285 A1**
(43) Date of publication of application: **20.03.2002**
(21) Application number: 01914187.8
(22) Date of filing: 21.03.2001
(51) Int. Cl.: H01L 27/12

(54) **PRODUCTION METHOD FOR BONDING WAFER AND BONDING WAFER PRODUCED BY THIS METHOD**

(30) Priority: 27.03.2000 JP 2000086255
(71) Applicant: SHIN-ETSU HANDOTAI COMPANY LIMITED, Chiyoda-ku Tokyo 100-0005 (JP)
(72) Inventor: ABE, Takao, c/o Isobe R & D Center, Annaka-shi, Gunma 379-0196 (JP); OHNUKI, Soumei, Sapporo-shi, Hokkaido 002-8074 (JP); SUZUKI, Shyuichi, Sapporo-shi, Hokkaido 063-0021 (JP); YOKOKAWA, Isao, c/o Isobe R & D Center, Annaka-shi, Gunma 379-0196 (JP)
(74) Representative: Cooper, John
(86) International application number: JP0102235
(87) International publication number: WO0173848

(57) **Abstract**

In a method for producing a bonded wafer comprising an ion implantation step where at least either hydrogen ions or rare gas ions are implanted into a first wafer from its surface to form a micro bubble layer (implanted layer) in the first wafer, a bonding step wherein the surface subjected to the ion implantation of the first wafer is bonded to a surface of a second wafer, and a delamination step where the bonded first wafer and second wafer are subjected to a heat treatment to delaminate the first wafer at the micro bubble layer, wherein the ion implantation is performed while temperature of the first' wafer is maintained at a temperature lower than 20°C in the ion implantation step. There is provided a method for producing a bonded wafer, which enables improvement of productivity and decrease of cost by reduction of implantation dose required for the delamination and bonding of wafers without causing breakage of the wafers by lowering delamination temperature in the ion implantation delamination method even when wafers having different thermal expansion coefficients are bonded.

## Description

### Technical Field

The present invention relates to the so-called ion implantation delamination method, in which a wafer (first wafer, bond wafer) implanted with hydrogen ions or rare gas ions is bonded to another wafer (second wafer, base wafer) and then delaminated by a heat treatment to produce a bonded wafer, and it relates to a method for producing a bonded wafer based on the ion implantation delamination method that can reduce dose of ions to be implanted and lower delamination temperature compared with conventional practice.

### Background Art

As a method for producing an SOI (Silicon On Insulator) wafer using the bonding method, there is conventionally known a technique comprising bonding two of silicon wafers via a silicon oxide film, for example, a method comprising forming an oxide film on at least one of such wafers, bonding the wafers to each other without interposing foreign matters between the surfaces to be bonded, and then subjecting them to a heat treatment at a temperature of 200-1200°C to enhance the bonding strength, as disclosed in Japanese Patent Publication (Kokoku) No. 5-46086.

The bonded wafer, of which bonding strength is enhanced by such a heat treatment, can be subjected to subsequent grinding and polishing processes. Therefore, an SOI layer for fabricating devices can be formed by reducing thickness of the wafer (first wafer, bond wafer) on which devices are to be fabricated to a desired thickness by grinding and polishing.

A bonded SOI wafer produced as described above has advantages of superior crystallinity of SOI layer and high reliability of buried oxide layer existing directly under the SOI layer. However, because it is produced through reduction of thickness of the first wafer by grinding and polishing, it suffers from a drawback that the reduction of thickness takes a lot of time and generates waste of the material. In addition, obtainable uniformity of the thickness of the SOI layer is only in such a degree of target thickness ± 0.3 µm or so at most.

Meanwhile, in connection with recent use of higher integration degree and higher processing velocity of semiconductor devices, further reduction of film thickness and improvement of film thickness uniformity are required as for the thickness of the SOI layer. Specifically, a film thickness and uniformity represented as 0.1 ± 0.01 µm or so are required.

A thin film SOI wafer having such a film thickness and film thickness uniformity cannot be realized as a bonded wafer by the conventional thickness reduction processing using only grinding and polishing. Therefore, the method called ion implantation delamination method or hydrogen ion delamination method was developed as a novel film thickness reduction technique as disclosed in Japanese Patent Laid-open (Kokai) Publication No. 5-211128.

This ion implantation delamination method is a technique for producing an SOI wafer, wherein an oxide film is formed on at least one of two silicon wafers, for example, hydrogen ions or rare gas ions are implanted into one wafer from its top surface to form a micro bubble layer (enclosed layer) in the silicon wafer, then the ion-implanted surface of the wafer is bonded to the other wafer via the oxide film, thereafter one of the wafers is delaminated as a thin film at the micro bubble layer as a cleavage plane (delaminating plane) by a heat treatment (delamination heat treatment), and the other bonded wafer is further subjected to a heat treatment (bonding heat treatment) to strengthen the bonding to obtain an SOI wafer.

In this method, the delaminated plane is obtained as a good mirror surface, and an SOI wafer having extremely high uniformity of the thickness of SOI layer can be obtained relatively easily. In addition, the method also has an advantage that one delaminated wafer can be reused and thus the material can be used effectively.

Further, by this method, it is also possible to directly bond silicon wafers to each other without an oxide film, and it can be used not only for a case where silicon wafers are bonded to each other, but also for a case where an ion-implanted silicon wafer is bonded to an insulator wafer having a different thermal expansion coefficient such as those of quartz, sapphire, silicon nitride, aluminum nitride and so forth or an ion-implanted insulator wafer is bonded to another wafer to obtain a wafer having a thin film of such materials and so forth.

Although this ion implantation delamination method is an extremely excellent method as a method for producing a bonded SOI wafer, it has the following problems for practical use.

One of the problems is higher production cost, because the implantation dose (dose) must be increased to some extent in order to cause the delamination. That is, an implantation dose exceeding 1 x 10¹⁶/cm² (for example, 5 x 10¹⁶/cm²) is required as the implantation dose for causing delamination as disclosed in Japanese Patent Laid-open (Kokai) Publication No. 5-211128. Therefore, the implantation time is prolonged, and increase of cost is invited due to reduction of throughput. Thus, it is desired to reduce the implantation dose.

Further, Japanese Patent Laid-open Publication No. 5-211158 describes that a temperature exceeding about 500°C is required for a heat treatment for causing delamination at an ion-implanted layer in a silicon wafer implanted with ions at a dose of the above-specified level and bonded to another wafer. However, there exists a problem that, in a case where a silicon wafer is bonded with a wafer having a thermal expansion coefficient different from that of silicon such as an insulator wafer, if the bonded wafers are subjected to a heat treatment at a temperature exceeding about 500°C, one of the wafers may be broken during heating or cooling. To solve this problem, the applicants of the present application proposed a method of repeating heat treatment and reduction of film thickness and a method of implanting deuterium ions in the previous applications (Japanese Patent Laid-open Publication Nos. 11-145438 and 11-330438). However, neither of these methods can be necessarily considered a simple method.

Furthermore, although the ion implantation delamination method provides an SOI wafer having extremely high uniformity of SOI layer thickness as described above and a mirror surface as the delaminated plane, the delaminated plane suffers from measurable surface roughness and crystal defects are generated by the ion implantation. Therefore, to eliminate these, it is necessary to polish the surface of SOI layer, although it may be done for a small amount. Although this polishing is mirror polishing using an extremely small stock removal for polishing (5 nm to 400 nm) called touch polish, it suffers from a problem that it may degrade thickness uniformity improved by the ion implantation delamination method with much trouble with increase of the stock removal for polishing.

### Disclosure of the Invention

The present invention was accomplished in view of the aforementioned problems, and its object is to provide a method for producing a bonded wafer, which enables improvement of productivity and decrease of cost by reduction of implantation dose required for the delamination and bonding of wafers without causing breakage of the wafers by lowering delamination temperature in the ion implantation delamination method even when wafers having different thermal expansion coefficients are bonded.

In order to achieve the aforementioned object, the method for producing a bonded wafer according to the present invention is a method for producing a bonded wafer comprising an ion implantation step where at least either hydrogen ions or rare gas ions are implanted into a first wafer from its surface to form a micro bubble layer (implanted layer) in the first wafer, a bonding step wherein the surface subjected to the ion implantation of the first wafer is bonded to a surface of a second wafer, and a delamination step where the bonded first wafer and second wafer are subjected to a heat treatment to delaminate the first wafer at the micro bubble layer, wherein the ion implantation is performed while temperature of the first wafer is maintained at a temperature lower than 20°C in the ion implantation step.

If the ion implantation is performed while maintaining the temperature of the first wafer at a temperature lower than 20°C, disorder of lattices in the wafer implanted with ions can be made small, and thus the implantation profile can be improved. As a result, the implantation dose required for the delamination can be reduced and breakage of wafers during the bonding heat treatment can be prevented by use of a lower delamination temperature.

In this case, the temperature of the first wafer is more preferably maintained at 0°C or lower during the aforementioned ion implantation step.

In order to enhance the improvement effect of the implantation profile, it is preferable to control the temperature of the first wafer to be 0°C or lower as described above. In particular, if liquid nitrogen, which it is relatively inexpensive and easily obtained, is used in order to maintain the temperature of the first wafer to be a temperature of 0°C or lower, it is possible to maintain the wafer at a low temperature as low as -196°C, and if liquid helium is used, it is possible to maintain the wafer at a low temperature as low as about -269°C. Thus, the profile can be made closer to the theoretical profile, and therefore the implantation dose can be further reduced and it is also advantageous for lowering the delamination temperature.

In the present invention, the heat treatment temperature during the aforementioned delamination step can be lower than 500°C.

According to the present invention, the implantation profile is improved, and therefore it becomes possible to cause the delamination at a temperature lower than 500°C as described above. Therefore, even when wafers having different thermal expansion coefficients are bonded, they can be bonded without generating breakage of the wafers.

Further, in the present invention, a silicon single crystal wafer can be used as the first wafer.

If a silicon single crystal wafer is used as the first wafer as described above, an SOI wafer that has very uniform SOI layer thickness can be produced at a low cost, and therefore it can be widely used for various devices.

Further, it is also preferable to preliminarily form an oxide film on the surface of the first wafer before the ion implantation.

This is because, if a thermal oxide film, a CVD oxide film or the like is formed on the surface before the ion implantation, degradation of the implantation profile (broadening along the depth direction) due to the channeling phenomenon during the ion implantation can be reduced, and generation of voids (unbonded portion) during the bonding with the second wafer can also be reduced.

Further, in the present invention, as the second wafer, a silicon single crystal wafer can be used, and a wafer having a thermal expansion coefficient different from that of the first wafer can also be used.

If a silicon single crystal wafer is used as the second wafer, i.e., the base wafer, a wafer excellent in flatness can be obtained, and moreover, a wafer having a large diameter of 200 mm or 300 mm or larger can also be obtained.

On the other hand, since the delamination temperature can be lowered according to the present invention, it becomes possible to produce a bonded wafer without causing breakage of wafers even when a wafer having a thermal expansion coefficient different from that of the first wafer is bonded. Therefore, for example, even if a silicon single crystal wafer is used as the first wafer and an insulator wafer consisting essentially of quartz, sapphire, silicon nitride, aluminum nitride or the like, which has a thermal expansion coefficient different from silicon, is used as the second wafer, they can be easily bonded without causing breakage.

Furthermore, an oxide film may be preliminarily formed on a surface of the second wafer before bonding.

By forming a thermal oxide film, a CVD oxide film or the like on the second wafer surface as described above, the generation of voids due to the bonding with the first wafer can be reduced.

Further, a bonded wafer of extremely high quality can be obtained by the method of the present invention.

In the present invention, in particular, an SOI wafer that has an SOI layer of extremely high thickness uniformity can be obtained, and there can be provided not only a bonded wafer consisting of bonded silicon wafers, but also a bonded wafer consisting of a silicon wafer bonded with an insulator wafer and a bonded wafer consisting of bonded insulator wafers.

As described above, according to the present invention, the implantation profile can be improved to obtain a sharp distribution in the ion implantation delamination method by forcibly cooling the wafer during the ion implantation to maintain it at a low temperature. As a result, the implantation dose required for the delamination can be reduced, thus productivity is improved and it becomes possible to reduce the cost.

Further, since the implantation profile is improved and the implantation damage layer in the wafer becomes thin, the surface roughness of the delaminated plane becomes small. As a result, the stock removal for polishing performed for the delaminated plane can be reduced, and therefore there can also be obtained an advantage that the degradation of precision for thin film layer thickness caused by polishing can be suppressed to the minimum extent.

Furthermore, since it also becomes possible to lower the delamination temperature, a bonded wafer of high quality can be produced without causing breakage of wafers and also without performing troublesome steps such as repetition of heat treatment, even when wafers having different thermal expansion coefficients are bonded.

### Brief Explanation of the Drawings

Fig. 1 is a schematic view of the ion implantation apparatus used in the present invention, which includes (A) a schematic view of the structure of the essential part of the apparatus, and (B) a typical view for illustrating a wafer holding part.
Fig. 2 is a graph showing the results of measurement of hydrogen implantation profile.
Fig. 3 is a graph showing the results of measurement of blister density after heat treatment.

### Best Mode for Carrying out the Invention

Hereafter, embodiments of the present invention will be explained in detail. However, the present invention is not limited to these.

In order to reduce the implantation dose required for the delamination and lower the delamination temperature in the ion implantation delamination method, the inventors of the present invention directed their attention to the temperature of the wafer during the ion implantation.

That is, in the conventional ion implantation delamination method, the temperature of the wafer subjected to the ion implantation is maintained at a temperature lower than the critical temperature at which the gas generated by implanted ions begins to be rapidly diffused and emitted from semiconductors, and in the case of silicon, it was presupposed that a implantation temperature of 20-450°C should be preferred, as disclosed in Japanese Patent Laid-open Publication No. 5-211128. Therefore, the hydrogen ion implantation is usually performed at room temperature in many cases. However, since the ions are implanted with high energy although the ion implantation is performed at room temperature, it is presumed that the temperature of the wafer reaches 60 to 70°C. Therefore, it is considered that the implanted hydrogen ions are diffused through the disordered lattices to some extent by heat, and they have a distribution more spreading along the depth direction of the wafer compared with the theoretically obtained implantation profile of the ion implanted layer.

Therefore, the inventors of the present invention conceived that, if a wafer was maintained at a temperature as low as possible by forcibly cooling the wafer during the ion implantation, the implantation profile would be improved and thus a sharp distribution near the theoretical profile based on the assumption of the absolute zero could be expected, and thus accomplished the present invention.

That is, the following experiments were performed in order to confirm the effect of the aforementioned ion implantation at a low temperature.

### (Experimental method)

First, a silicon single crystal wafer of plane orientation (100) was prepared, on which a silicon oxide film having a thickness 400 nm was formed by thermal oxidation on the surface. Hydrogen ions were implanted through the surface oxide film of this wafer under the following conditions.
Implantation energy:. 88 keV
Dose: 5 x 10¹⁶/cm², 6.5 x 10¹⁶/cm²
Wafer temperature: room temperature (25°C), low temperature (-20°C, -55°C)

### (Experimental apparatus)

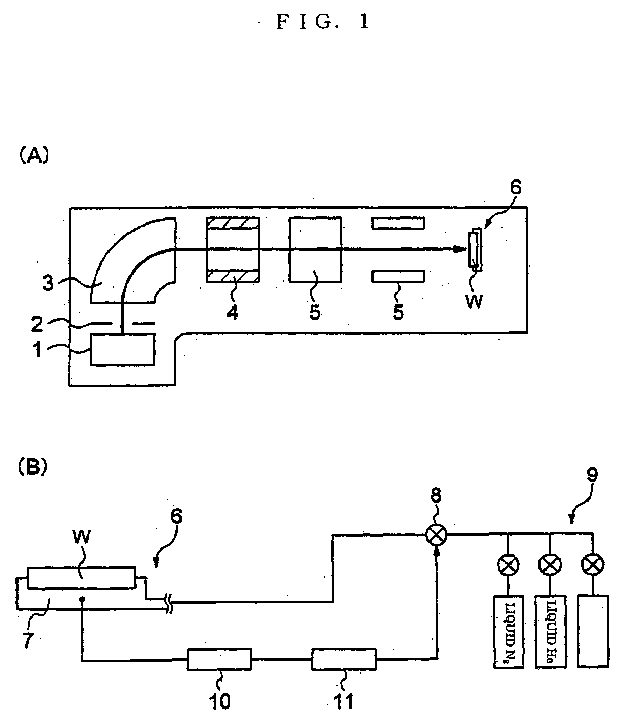

The outline of the used apparatus was similar to that of a usual ion implantation apparatus as shown in Fig. 1A. However, it had a part for holding a wafer that can be cooled with a refrigerant such as liquid nitrogen and liquid helium, whereas it is usually cooled only with cooling water, and provided with temperature controlling function so that the temperature of the wafer can be controlled as shown in Fig. 1B.

That is, as shown in Fig. 1A, the ion implantation apparatus comprises an ion source 1 that ionizes a raw material of ions, electrodes 2 withdrawing such ions, a mass spectrometer 3 that separates various types of the withdrawn ions, an accelerator 4 that accelerates the ions with high voltage, and multiple deflection plates 5 for uniformly irradiating the wafer W held on a holding part 6 with ion beams.

As shown in Fig. 1B, in the part 6 for holding the wafer W, refrigerant tanks 9 are connected to a wafer holder 7 for holding the wafer W via a control valve 8, so that the wafer W can be cooled by using a desired refrigerant that is selected depending on the temperature at which the wafer W should be maintained. The temperature of the wafer holder 7 is measured by a thermometer 10, and data obtained by it are sent to a thermoregulator 11. The thermoregulator 11 controls flow rate and temperature of the refrigerant by controlling opening degree of the control valve 8 and so forth so that the wafer W can be maintained at a predetermined temperature.

### (Evaluation method)

A wafer implanted with hydrogen ions was evaluated by the following three kinds of methods.
1. Measurement of hydrogen implantation profile by SIMS (secondary ion mass spectrometry apparatus)
2. Observation of blisters (bubbles) after heat treatment by SEM (scanning electron microscope)
3. Observation of wafer cross section by TEM (transmission electron microscope) before and after heat treatment

### (Result)

### 1. Hydrogen implantation profile

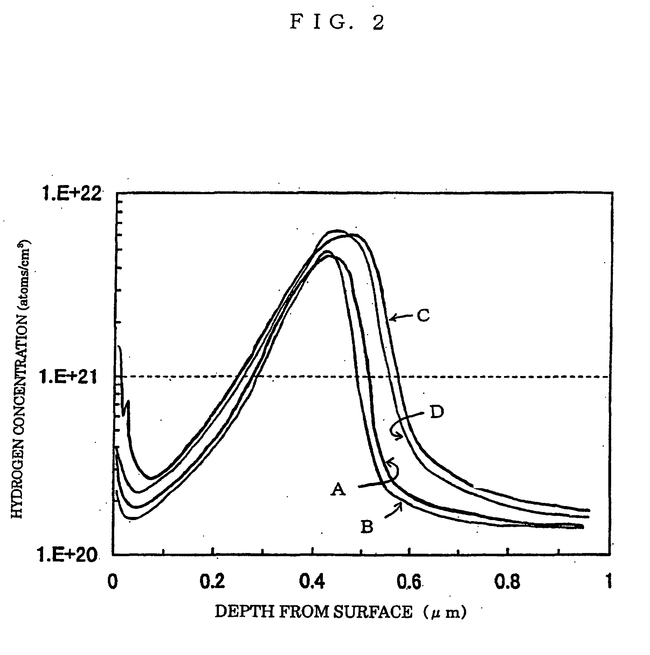

Implantation profiles of wafers at a dose of 5 x 10¹⁶/cm² (Curve A: implantation at room temperature, Curve B: implantation at -55°C), and implantation profiles of wafers at a dose of 6.5 x 10¹⁶/cm² (Curve C: implantation at room temperature, Curve D: implantation at -55°C) are shown in Fig. 2. It can be seen that profiles having a narrower breadth along the depth direction, i.e., a sharper shape, were obtained by the low temperature implantation for the both doses.

### 2. Observation result for blisters after heat treatment

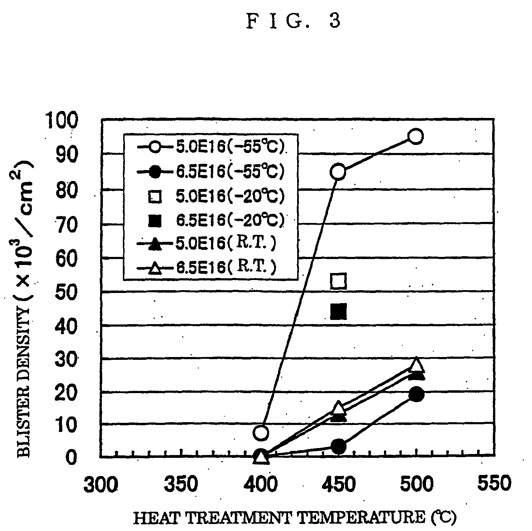

Since density of blisters after heat treatment directly relates to delamination, blister density of each wafer was measured by SEM observation of wafer surface after the wafer was subjected to a heat treatment at a temperature of 400, 450 or 500°C for 30 minutes and shown in Fig. 3.

From the results shown in Fig. 3, it was found that blisters were generated at extremely higher densities in the wafer for which the implantation was performed at -55°C at a dose of 5 x 10¹⁶/cm² (plotted with white circles) and the wafers for which the implantation was performed at -20°C at a dose of 5 x 10¹⁶/cm² or 6.5 x 10¹⁶/cm² (plotted with white squares and black squares) compared with the wafers for which the implantation was performed at room temperature at the same doses (plotted with white triangles and black triangles). Therefore, it can be seen that the low temperature implantation can lower the heat treatment temperature required for the delamination compared with the room temperature implantation. For example, it can be seen that the temperature can be lowered to a temperature lower than 500°C, in particular, 450°C or lower. The reason why blisters could not be obtained at a high density in the wafer for which the implantation was performed at -55°C at a dose of 6.5 x 10¹⁶/cm² (plotted with black circles) will be described later.

### 3. Result of observation of wafer cross section by TEM before and after heat treatment

As for the wafer for which the implantation was performed at -55°C, a portion of wafer cross section near the implanted layer was observed by TEM before and after a heat treatment at 400°C. When the dose was 5 x 10¹⁶/cm², defects (micro bubbles) required for the delamination were observed at the implanted layer before the heat treatment, and cracks consisting of aggregated blisters were observed near the center part of the implanted layer after the heat treatment. On the other hand, when the dose was 6.5 x 10¹⁶/cm², defects required for the delamination were not observed at the implanted layer before the heat treatment and crystals of the portion corresponding to the implanted layer became amorphous. Further, after the heat treatment, blisters near the center part of the implanted layer, which were observed at the dose of 5 x 10¹⁶/cm², were not observed and only a few blisters were observed at the boundary of the amorphous layer and the deeper crystal layer.

These indicate that, as for the low temperature implantation (-55°C in this case), the delamination is caused by the subsequent heat treatment at the dose of 5 x 10¹⁶/cm², whereas the delamination is unlikely to be caused by the heat treatment at the 'dose of 6.5 x 10¹⁶/cm². This was considered to be caused because the distribution of hydrogen was improved by the low temperature implantation compared with the room temperature implantation so that defects for the delamination were effectively formed, and as a result, the dose of 6.5 x 10¹⁶/cm² became excessive so that the crystals became amorphous, not forming defects, and generation of blisters became difficult.

From the above results, it was found that, by performing the low temperature implantation, the dose required for the delamination can be reduced, and the delamination temperature can also be lowered. Further, it was also found that, when the low temperature implantation is performed, the dose must be suitably controlled according to the wafer temperature, because an excessive dose makes the implanted layer amorphous and thus it becomes difficult to cause the delamination.

Furthermore, as described above, the low temperature implantation improves the implantation profile to narrow the breadth of the implanted hydrogen ions along the depth direction. Thus, surface roughness of the delaminated plane after the delamination tends to become small. Therefore, the stock removal for the polishing performed for removing the surface roughness of the delaminated plane can be reduced and there can also be obtained an effect that uniformity of film thickness of the SOI layer formed by the ion implantation delamination method is not degraded.

Thus, in the ion implantation into the first wafer in the ion implantation delamination method, if the ion implantation is performed with maintaining the wafer at a temperature lower than 20°C by forced cooling, while it has conventionally been performed at a temperature of 20°C or higher, the disorder of the lattices in the wafer to be implanted with ions can be reduced and thus the implantation profile can be improved. As a result, the implantation dose required for the delamination can be reduced and breakage of wafer during the bonding heat treatment can be prevented by decrease of the delamination temperature.

While the temperature of the wafer to be implanted with ions is most preferably the absolute zero in order to minimize the disorder of lattices, if it is maintained to be a temperature lower than 20°C, the effect of improving implantation profile can surely be obtained compared with the conventional implantation performed at 20-450°C.

In particular, in order to enhance the effect of improving implantation profile, the temperature is preferably 0°C or lower. To maintain such a temperature, liquid nitrogen, which is relatively inexpensive and easily obtained, can be used to maintain the temperature as low as -196°C. Further, a low temperature up to about -269°C can be maintained by using liquid helium and thus the profile can be made close to the theoretical profile. Therefore, the implantation dose can be further reduced, and it is also advantageous for decrease of the delamination temperature.

Moreover, since the implantation profile is improved by the low temperature ion implantation, the heat treatment temperature in the delamination step can be lowered to a temperature lower than 500°C, in particular, 450°C or lower. Further, if the implantation is performed at an extremely low temperature, it may become possible to attain the delamination at room temperature without performing the delamination heat treatment.

As described above, while the delamination heat treatment must have conventionally been performed at a temperature of 500°C or higher, it becomes possible to attain the delamination at a temperature lower than 500°C. Therefore, breakage of wafers is not caused as in the conventional techniques even when wafers having different thermal expansion coefficients are bonded as in the case of bonding of a silicon wafer and an insulator wafer, and there is also obtained an advantage that it is not required to perform a troublesome operation such as repetition of heat treatment and film thickness reduction.

In the present invention, wafers to be bonded can be arbitrarily selected according to the purpose, and are not particularly limited. However, if a silicon single crystal wafer is used as the first wafer, for example, an SOI wafer having an extremely uniform SOI layer can be produced at a low cost, and it can be widely used for various devices. Moreover, in case of silicon wafers, it is suitable for the production of wafers of larger diameter.

Further, an oxide film is preferably formed beforehand on the surface of the first wafer before the implantation. This is because, if a thermal oxide film or another oxide film such as CVD oxide film is formed on the surface before the ion implantation, broadening of the implantation profile along the depth direction due to the channeling phenomenon during the ion implantation can be reduced, and thus the implantation profile can be more stabilized. Further, if an oxide film is formed on the first wafer, generation of voids that constitute unbonded portion during the bonding can also be reduced.

As the second wafer, a silicon single crystal wafer can be used, and wafers other than silicon can also be used depending on the purpose.

If a silicon single crystal wafer is used as the second wafer, i.e., a base wafer (support substrate), an extremely flat wafer can be obtained. Thus, flatness of wafers after bonding is also improved, and it will be preferable also for the subsequent device production step. In addition, it is also relatively easy to obtain wafers having a large diameter of 200 mm or 300 mm or larger.

Furthermore, since the delamination temperature can be lowered according to the present invention, wafer becomes unlikely to be broken during the delamination heat treatment. Therefore, it is possible to use various wafers having a thermal expansion coefficient different from that of the first wafer as the second wafer. In this case, if a silicon single crystal wafer is used as the first wafer and an insulator wafer consisting essentially of quartz, sapphire, silicon nitride, aluminum nitride or the like is used as the second wafer, there can be obtained an SOI wafer suitable for TFT-LCD.

Furthermore, it is also preferable to preliminarily form an oxide film also on the surface of the second wafer, and then used for the bonding. By doing so, generation of voids can be prevented during the bonding with the first wafer.

Hereafter, the present invention will be specifically explained with reference to the following examples of the present invention and comparative example. However, the present invention is not limited by these.

### (Example 1)

As the first wafer, there was prepared a silicon single crystal wafer having a diameter of 150 mm, plane orientation of (100) and thickness of 625 µm, on which a silicon oxide film having a thickness of 400 nm was formed on the surface by thermal oxidation. This wafer was set on the wafer holder 7 of the ion implantation apparatus shown in Fig. 1 and implanted with hydrogen ions through the oxide film from the wafer surface with the conditions of an implantation energy of 88 keV and a dose of 5 x 10¹⁶/cm² in a state that the wafer was maintained at a low temperature of -55°C by using the thermoregulator 11. Subsequently, the wafer after the ion implantation and a silicon single crystal wafer (second wafer) having the same shape as the first wafer, on which an oxide film was not formed on the surface, were bonded with each other at room temperature and subjected to a delamination heat treatment at 420°C for 30 minutes under a nitrogen atmosphere.

As a result, the first wafer implanted with ions was successfully delaminated at the ion-implanted layer and an SOI wafer having an SOI layer with a thickness of about 0.4 µm was produced although the wafers were subjected to a heat treatment at a lower temperature compared with the conventional practice, i.e., 420°C.

### (Comparative Example 1)

Wafers produced with the same conditions as those of Example 1 except that the wafer temperature during the ion implantation was 25°C and bonded with each other at room temperature were subjected to a heat treatment at 420°C for 30 minutes under a nitrogen atmosphere as in Example 1.

As a result, delamination was not generated at the ion-implanted layer, but in order to delaminate the first wafer, it was required to perform a heat treatment at a higher temperature or further increase the ion implantation dose.

### (Example 2)

As the first wafer, there was prepared a silicon single crystal wafer having a diameter of 100 mm, plane orientation of (100) and thickness of 200 µm, on which a silicon oxide film having a thickness of 400 nm was formed on the surface by thermal oxidation. This wafer was set on the wafer holder 7 of the ion implantation apparatus shown in Fig. 1 and implanted with hydrogen ions through the oxide film from the wafer surface with the conditions of an implantation energy of 88 keV and a dose of 5 x 10¹⁶/cm² in a state that the wafer was maintained at a low temperature of -55°C by using the thermoregulator 11. Subsequently, the wafer after the ion implantation and a quartz wafer (second wafer) having the same shape as the first wafer were bonded with each other at room temperature and subjected to a heat treatment at 420°C for 30 minutes under a nitrogen atmosphere.

As a result, the wafer implanted with ions was successfully delaminated at the ion-implanted layer without breakage due to the heat treatment, and an SOI wafer having an SOI layer with a thickness of about 0.4 µm on the quartz wafer could be produced.

The present invention is not limited to the embodiments described above. The above-described embodiments are mere examples, and those having the substantially same technical characteristics as those described in the appended claims and providing similar functions and advantages are all included in the scope of the present invention.

## Claims

1. A method for producing a bonded wafer comprising an ion implantation step where at least either hydrogen ions or rare gas ions are implanted into a first wafer from its surface to form a micro bubble layer (implanted layer) in the first wafer, a bonding step wherein the surface subjected to the ion implantation of the first wafer is bonded to a surface of a second wafer, and a delamination step where the bonded first wafer and second wafer are subjected to a heat treatment to delaminate the first wafer at the micro bubble layer, wherein the ion implantation is performed while temperature of the first wafer is maintained at a temperature lower than 20°C in the ion implantation step.

2. The method for producing a bonded wafer according to Claim 1, wherein the temperature of the first wafer is maintained at 0°C or lower during the ion implantation step.

3. The method for producing a bonded wafer according to Claim 1 or 2, wherein the heat treatment temperature during the delamination step is lower than 500°C.

4. The method for producing a bonded wafer according to any one of Claims 1-3, wherein a silicon single crystal wafer is used as the first wafer.

5. The method for producing a bonded wafer according to any one of Claims 1-4, wherein an oxide film is preliminarily formed on the surface of the first wafer before the ion implantation.

6. The method for producing a bonded wafer according to any one of Claims 1-5, wherein a silicon single crystal wafer is used as the second wafer.

7. The method for producing a bonded wafer according to any one of Claims 1-6, wherein a wafer having a thermal expansion coefficient different from that of the first wafer is used as the second wafer.

8. The method for producing a bonded wafer according to any one of Claims 1-7, wherein an oxide film is preliminarily formed on a surface of the second wafer before bonding.

9. A bonded wafer, which is produced by the method according to any one of Claims 1-8.
